**Europäisches Patentamt**

**European Patent Office**

**Office européen des brevets**

(11) Veröffentlichungsnummer: **0 074 436**
**B1**

(12) **EUROPÄISCHE PATENTSCHRIFT**

(45) Veröffentlichungstag der Patentschrift:
**10.04.85**

(21) Anmeldenummer: **81201007.2**

(22) Anmeldetag: **10.09.81**

(51) Int. Cl.⁴: **H 03 M 1/68**

(54) Monolithisch integrierter D/A-Wandler mit bipolaren Transistoren.

(43) Veröffentlichungstag der Anmeldung:
**23.03.83 Patentblatt 83/12**

(45) Bekanntmachung des Hinweises auf die Patenterteilung:
**10.04.85 Patentblatt 85/15**

(84) Benannte Vertragsstaaten:
**DE FR GB IT NL**

(56) Entgegenhaltungen:
**DE - A - 2 532 580**
**DE - A - 2 803 099**
**FR - A - 2 291 649**
**FR - A - 2 404 957**
**GB - A - 2 069 265**
**US - A - 3 890 611**

**A User's Handbook of D/A and A/D Converters by Eugene R. Hnatek (1976)S. 106 Fis 4/19**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Lang, Manfred, Breitenfeldstrasse 27, D-7832 Kenzingen (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

**Beschreibung**

Die Erfindung beschäftigt sich mit einem integrierten D/A-Wandler mit bipolaren Transistoren als Stromquellentransistoren und Schaltertransistoren für schnelle D/A-Wandlungen im MHz-Bereich. Bei der Wahl des Typs eines solchen Wandlers spielt, wie allgemein bei einer monolithischen Integration bekannt ist, die benötigte Fläche an Halbleiterplattenmaterial eine Rolle, da mit geringer werdendem Flächenbedarf die Ausbeute pro Platte steigt.

Bei D/A-Wandlern des Typs mit gewichteten Stromquellen wird dieses Problem nach der DE-AS Nr. 2803099 dadurch gelöst, dass nicht nur eine der Wertigkeit der Stromquellen entsprechende Anzahl von gleichartigen parallelgeschalteten Stromquellentransistoren, sondern auch noch Schaltertransistoren verwendet werden, welche in gleicher Weise aus parallelgeschalteten gleichartigen Schaltertransistoreinheiten bestehen. Unter dem Begriff der Gleichartigkeit sollen hier und im folgenden Halbleiterkomponenten fallen, welche identische Abmessungen und identische Verläufe der Störstellenkonzentration (Dotierungsprofile) aufweisen, wie es sich bezüglich der Störstellenprofile bei gleichzeitiger Herstellung der Zonen ergibt.

D/A-Wandler des Typs der gewichteten Stromquellen haben aber den Nachteil, dass schon bei wenigen Bits von etwa 5 der Flächenbedarf und damit auch die Kapazitäten für eine schnelle D/A-Wandlung gross werden. Gleiches gilt für D/A-Wandler mit Widerstandsnetzwerken entsprechend dem Buch von U. Tietze und Ch. Schenk „Halbleiter-Schaltungstechnik" (1980), S. 635 bis 637. Werden D/A-Wandler dieses Typs nämlich monolithisch integriert, dann steigt mit steigender Bitanzahl der zur Realisierung der Widerstände erforderliche Flächenbedarf mit den RC-Produkten, falls zur Erzielung monotoner Wandlerkennlinien parallel- oder in Serie geschaltete Widerstände gleicher Struktur und Dotierungsprofile verwendet werden.

Es dürfte einleuchten, dass ein monolithisch integrierter D/A-Wandler mit grösserem Flächenbedarf infolge vieler Widerstände im Netzwerk naturgemäss schon aufgrund der PN-Kapazitäten relativ langsam ist. Bei schnellen D/A-Wandlern soll die Summation der Einzelspannungen im Kollektorkreis möglichst wenig von RC-Kettenleitern beeinflusst werden. Diese begrenzen den Frequenzbereich des Wandlers.

Es ist bei schnellen D/A-Wandlern ferner erwünscht, bitweise gleiche Schaltzeiten zu erhalten, um eine Bitüberlappung *(glitches)* zu verhindern. Eine Lösung dieses Problems liegt daher im Rahmen der Erfindung.

Aufgabe der Erfindung ist die Angabe eines monolithisch integrierten D/A-Wandlers mit einem ausgangsseitig möglichst kleinen RC-Produkt, der die obengenannten Nachteile bekannter Wandler weitgehend vermeidet, insbesondere für Bitzahlen von mehr als 5.

Die Erfindung geht aus von dem aus „A User's Handbook of D/A and A/D Converters" von Eugene R. Hnatek (1976), S. 106, Fig. 4/19, bekannten, monolithisch integrierten D/A-Wandler mit bipolaren Stromquellentransistoren, welche teilweise aus parallelgeschalteten gleichartigen Stromquellentransistoreinheiten bestehen und deren Basiszonen an einer Referenzspannung liegen, gemäss dem Oberbegriff des Anspruchs 1. Bei diesem monolithisch integrierten D/A-Wandler liegen die Kollektoranschlüsse der zweiten Transistoren jedes der Paare der bipolaren Schaltertransistoren, welche Differenzverstärker bilden, unmittelbar am Ausgang des Wandlers. Beim Wandler nach der Erfindung wird dagegen von dem Prinzip abgegangen, sämtliche Kollektoranschlüsse der zweiten Transistoren der Paare von bipolaren Schaltertransistoren unmittelbar an den Ausgang des Wandlers zu legen.

Die Erfindung betrifft somit einen monolithisch integrierten D/A-Wandler gemäss dem Oberbegriff des Anspruchs 1.

Bei der Erfindung wird, wie aus FR-A Nr. 2291649 bekannt, von dem Grundgedanken ausgegangen, zur Ersparnis von Halbleiteroberfläche den Wandler in einen ersten Wandlerteil mit gewichteten Widerständen und in einen zweiten Wandlerteil mit gewichteten Strömen aufzuteilen.

Die obengenannte Aufgabe der Angabe eines monolithisch integrierten D/A-Wandlers mit einem ausgangsseitig kleinen RC-Produkt wird erfindungsgemäss durch die im kennzeichnenden Teil des Anspruchs 1 angegebene Ausbildung gelöst.

Die Erfindung wird im folgenden anhand der Zeichnung näher erläutert, deren

Fig. 1 das Schaltbild des bekannten D/A-Wandlers der eingangs genannten Literaturstelle veranschaulicht, von dem bei der Erfindung ausgegangen wird, und deren

Fig. 2 das Schaltbild eines bevorzugten Ausführungsbeispiels des monolithisch integrierten D/A-Wandlers nach der Erfindung zeigt.

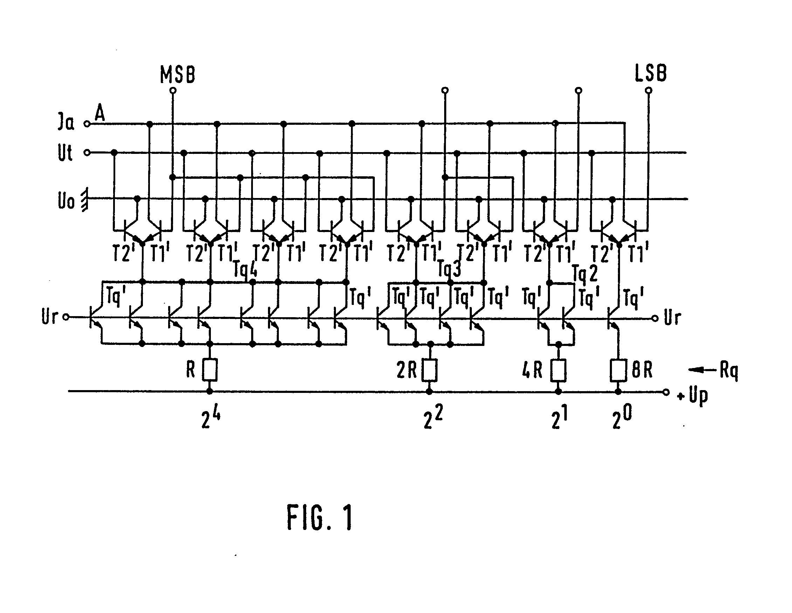

Beim bekannten D/A-Wandler gemäss Fig. 1 sind, wie beim Wandler nach der Erfindung, bipolare Stromquellentransistoren Tq1 bis Tq4 vorgesehen, welche bis auf den Stromquellentransistor für das LSB zur Stromaufteilung in Stromquellentransistoreinheiten Tq' aufgeteilt sind. Die Basiszonen der Stromquellentransistoren Tq1 bis Tq4 bzw. die Stromquellentransistoreinheiten Tq' liegen an einer Referenzspannung Ur, mittels derer die Grösse der Schaltströme und damit die Ausgangsspannung Va des Wandlers festgelegt wird. Die Emitterzonen der Stromquellentransistoren Tq1 bis Tq4 sind über je einen Emitterwiderstand Rq mit unterschiedlichen Widerstandswerten mit einer Flussspannungsquelle Up positiven Vorzeichens bezüglich der NPN-Stromquellentransistoren Tq1 bis Tq4 verbunden. Die Kollektoren der Stromquellentransistoren sind mit je einen einen Differenzverstärker bildenden Paar von bipolaren Schaltertransistoren T1' und T2' kontaktiert. Zur Stromaufteilung sind die Paare von Schaltertransistoren T1 mit T2 ebenfalls in Schaltertransistorein-

heiten T1' mit T2' aufgeteilt. Während die Basisanschlüsse der ersten Transistoren T1 bzw. T1' an den Bitleitungen liegen, liegen die Basisanschlüsse der zweiten Transistoren T2 bzw. T2' an der Schwellwertspannung Ut, welche die Umschaltspannung der von den Schaltertransistorpaaren gebildeten Differenzverstärker bestimmen. Dementsprechend werden die einzelnen Ströme der Stromquellentransistoren Tq zwischen der Leitung des Bezugspotentials Uo und dem Ausgang A des Wandlers umgeschaltet.

Fig. 1 veranschaulicht, dass der Flächenaufwand bei dem bekannten, monolithisch integrierten D/A-Wandler exponentiell mit der Bitanzahl ansteigt, falls von dem Grundsatz nicht abgegangen wird, ausschliesslich gleichartige Transistoreinheiten und Widerstandseinheiten zu verwenden. Eine solche Forderung ist aber im Hinblick auf die Erzielung monotoner Kennlinien unerlässlich.

Im übrigen hat der bekannte Wandler den Nachteil, dass die Schaltertransistoreinheiten T1', T2' keine gleichen Ströme schalten, so dass unterschiedliche Schaltzeiten erreicht werden. Zur Verhinderung von *glitches* sind aber gleiche Schaltzeiten erforderlich.

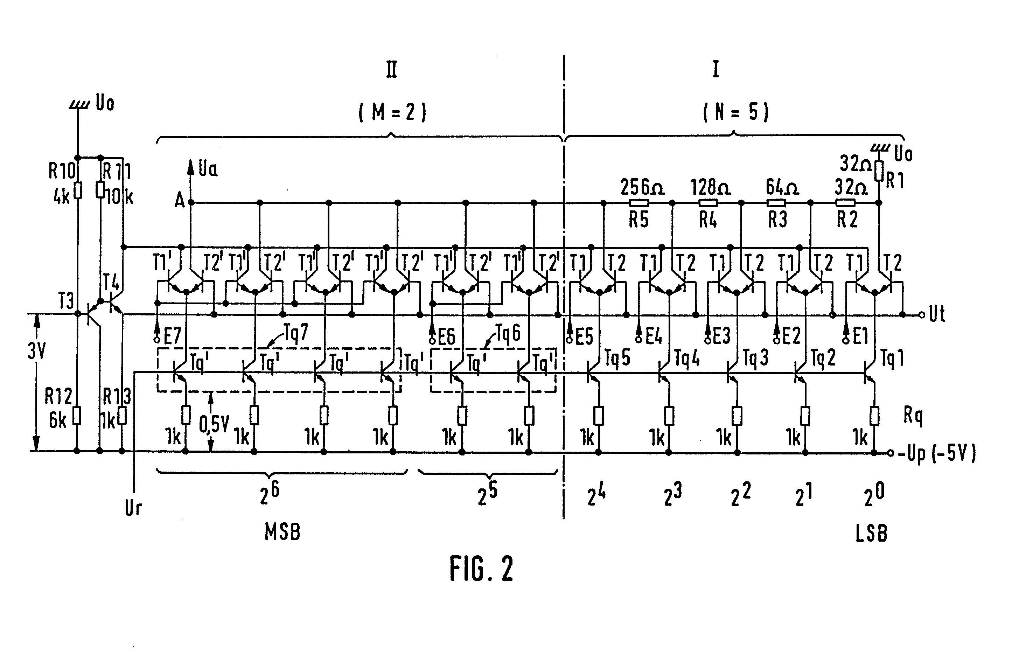

Demgegenüber werden beim D/A-Wandler nach der Erfindung gemäss Fig. 2 bitweise gleiche Ströme geschaltet, da gleichartige Schaltertransistoreinheiten bzw. Schaltertransistoren T1', T2' bzw. T1, T2 gleiche Ströme von gleichartigen Stromquellentransistoreinheiten bzw. Stromquellentransistoren Tq' bzw. Tq1 bis Tq5 schalten, deren Emitteranschlüsse über je einen gleichgrossen Widerstand Rq mit der Flussspannungsquelle –Up verbunden sind.

Eine erhebliche Verbesserung des bekannten Wandlers hinsichtlich des Flächenaufwandes wird bei dem Wandler nach der Erfindung aber bereits dadurch erreicht, dass der Wandler in einen ersten N-Bit-Wandlerteil I mit gewichteten Widerständen und in einen zweiten M-Bit-Wandlerteil II mit gewichteten Strömen aufgeteilt ist. Während im zweiten Wandlerteil II die Kollektoranschlüsse der zweiten Transistoren T2' unmittelbar am Ausgang A des Wandlers liegen, liegen die Kollektoren der entsprechenden zweiten Transistoren T2 im ersten Wandlerteil I bis auf den ausgangsseitig angeordneten über mindestens einen der Widerstände R2 bis Rn, beim Ausführungsbeispiel gemäss Fig. 2 R2 bis R5, mittelbar an diesem Ausgang A. Diese Widerstände R2 bis R5 liegen mit dem Widerstand R1 in Reihe zwischen dem Bezugspotential Uo und dem Ausgang A und sind entsprechend der Beziehung $Rn = 2^{n-2} \cdot Ro$ n=2 bis n dimensioniert. Für den 5-Bit-Wandlerteil I sind fünf Widerstände mit den Werten $R1 = 32\,\Omega$, $R2 = 32\,\Omega$, $R3 = 64\,\Omega$, $R4 = 128\,\Omega$ und $R5 = 256\,\Omega$ vorgesehen, deren Verbindungspunkte mit je einem Kollektoranschluss der zweiten Transistoren T2 je einer der Schaltertransistorpaare kontaktiert ist. Der ausgangsseitige Anschluss des letzten Widerstandes R5 liegt unmittelbar am Ausgang und am Kollektor des zweiten Transistors des fünften Schaltertransistorpaares.

Es ist bekannt, anstelle einer Reihenschaltung von n Widerständen mit abgestuften Widerstandswerten ein R/2R-Netzwerk zu verwenden, da ein solches Netzwerk ohne weiteres leicht aus gleichartigen diffundierten Widerständen aufgebaut werden kann, so dass die Fertigungsschwankungen sich gleichartig auf die Bitwerte auswirken. Derselbe Vorteil kann aber auch bei der Reihenschaltung im ersten Wandlerteil I des Wandlers nach der Erfindung dadurch erzielt werden, dass die Widerstände R3 bis R5 mit dem von Ro abweichenden Wert aus je einer Serienschaltung von gleichartigen Widerständen des Widerstandswertes von Ro bestehen.

Beim Wandler gemäss dem Ausführungsbeispiel der Fig. 2 ist im übrigen je eines der Paare von Schaltertransistoreinheiten bzw. Schaltertransistoren T1, T2, T1' und T2' mit je einer der Stromquellentransistoreinheiten Tq1 bis Tq5 und Tq' in Serie geschaltet. Ausserdem sind die Emitteranschlüsse der Stromquellentransistoren Tq1 bis Tq5 bzw. Stromquellentransistoreinheiten Tq' über je einen gleichgrossen Widerstand Rq mit der Flussspannungsquelle Up verbunden. Dadurch wird erreicht, dass sämtliche Schaltertransistoren T1, T2, T1' und T2' die gleichen Ströme über gleiche Innenwiderstände schalten, da diese gleiche Abmessungen und gleiche Dotierungsprofile aufweisen. Es sind daher gleiche Schaltzeiten gewährleistet, so dass *glitches* minimal sind.

Die Verwendung einer Reihenschaltung R2 bis Rn in dem Wandlerteil II nach der Erfindung anstelle des bekannten R/2R-Netzwerkes hat im übrigen den Vorteil, dass sehr geringe PN-Kapazitäten realisierbar sind, die letztes Endes bei Änderung eines Wortes, dessen Bit an die Eingänge E1 bis E7 angelegt wird, auf- bzw. umgeladen werden müssen. Bei dem Ausführungsbeispiel eines D/A-Wandlers gemäss der Fig. 2 nach der Erfindung ist ferner eine Spannungsquelle mit verschwindend kleinem Innenwiderstand gegen das Bezugspotential Uo vorgesehen, welche die Transistoren T3 und T4 und die Widerstände R10, R11, R12 und R13 aufweist. Diese Spannungsquelle liefert die Schwellwertspannung Ut, die an den Basen der zweiten Transistoren T2 bzw. T2' der Schaltertransistorpaare anliegt. Durch den verschwindend kleinen Innenwiderstand der Spannungsquelle wird erreicht, dass die Basen der in Basisschaltung betriebenen zweiten Transistoren hochfrequenzmässig praktisch an dem Bezugspotential liegen und die Spannungsrückwirkung über die zweiten Transistoren auf Eingang des Schalters vernachlässigbar wird.

Wie im Prinzip bereits bekannt ist, werden sowohl die Paare von Schaltertransistoreinheiten T1', T2' bzw. die Paare von Schaltertransistoren untereinander als auch die Stromquellentransistoren Tq und Stromquellentransistoreinheiten Tq' untereinander in denselben Abmessungen und mit derselben Störstellenverteilung hergestellt. Dies bedeutet, dass deren Zonen gleichzeitig hergestellt werden. Zu deren Herstellung eignet sich beispielsweise die sogenannte 3D-Technologie, bei der die Dotierungen der Zonen gleichzeitig während je eines maskierten Implantationsprozesses aufgebracht und gleichzeitig während eines nach dem Aufbringen erfolgenden Diffusionsprozesses in den Halbleiterkörper eingebracht werden, wie im Prinzip aus der Zeitschrift „Electronics" vom 7. August 1975, S. 101 bis 106, bekannt ist. In gleicher Weise werden die Schaltertransistorpaare im zweiten Wandlerteil II hergestellt und aus parallelgeschalteten Paaren von gleichartigen Transistoren T1' und T2' mit identischen Abmessungen und identischen Störstellenverteilungen aufgebaut.

Die Anwendung der Lehre der Erfindung ist besonders günstig, wenn man einen monolithisch integrierten D/A-Wandler mit einem ersten 5-Bit-Wandlerteil I und einem zweiten 2-Bit-Wandlerteil II verbindet. Bei einem solchen 7-Bit-Wandler nach der Erfindung wird eine beachtliche Einsparung an Halbleiteroberfläche gegenüber herkömmlichen Wandlern erzielt.

## Patentansprüche

1. Monolithisch integrierter D/A-Wandler mit bipolaren Stromquellentransistoren (Tq), deren Basiszonen gemeinsam an einer Referenzspannung (Ur) liegen, deren Emitterzonen über je einen Emitterwiderstand (Rq) mit einer Flussspannungsquelle (−Up) verbunden sind, und die teilweise aus gleichartigen Stromquellentransistoreinheiten bestehen, und deren einzelne Kollektorzonen mit den Emittern mindestens eines Paares von bipolaren Schaltertransistoren kontaktiert sind, welche zur Umschaltung der Ströme der einzelnen Stromquellentransistoren (Tq) zwischen den Bezugspotentialen (Uo) und dem Ausgang (A) dienen und die teilweise aus Paaren von gleichartigen Schaltertransistoreinheiten bestehen, wobei
— die Basisanschlüsse der ersten Transistoren (T1) der Schaltertransistorpaare an je einer der Bitleitungen (E),
— die Kollektoranschlüsse dieser ersten Transistoren gemeinsam an dem Bezugspotential (Uo),
— die Basisanschlüsse der zweiten Transistoren (T2) der Schaltertransistorpaare gemeinsam am Ausgang einer Spannungsquelle (Ut), und
— die Kollektoranschlüsse der zweiten Transistoren am Ausgang (A) des Wandlers liegen, dadurch gekennzeichnet,
— dass der Wandler in einen ersten N-Bit-Wandlerteil (I) mit gewichteten Widerständen und in einen zweiten M-Bit-Wandlerteil (II) mit gewichteten Strömen aufgeteilt ist, in welchem zweiten Wandlerteil (II) die Kollektoranschlüsse der zweiten Transistoren (T2') gemeinsam unmittelbar am Ausgang (A) des Wandlers liegen,
— dass zwischen dem Bezugspotential (Uo) und dem Ausgang (A) im ersten Wandlerteil (I) eine Reihenschaltung von n Widerständen liegt, deren erster Widerstand (R1) einen Widerstand von Ro und deren weitere Widerstände (R2-Rn) die Werte $Rn = 2^{n-2} \cdot Ro$ für n=2 bis n aufweisen, und

— dass je einer der Verbindungspunkte der n Widerstände (R1 ... Rn) mit je einem Kollektoranschluss der zweiten Transistoren (T2) je einer der Schaltertransistorpaare kontaktiert ist und der ausgangsseitige Anschluss des letzten Widerstandes (Rn) unmittelbar am Ausgang (A) und am Kollektor des zweiten Transistors (T2) des n-ten Schaltertransistorpaares liegt, so dass die Kollektoren der zweiten Transistoren (T2) im ersten Wandlerteil (I) bis auf den ausgangsseitig angeordneten über mindestens einen der Widerstände R2 bis Rn mittelbar am Ausgang (A) liegen.

2. D/A-Wandler nach Anspruch 1, dadurch gekennzeichnet, dass die Widerstände (R3, R4 ... Rn) mit dem von Ro abweichenden Wert aus je einer Serienschaltung von gleichartigen Widerständen des Widerstandswertes von Ro bestehen, welche dieselben Abmessungen und dieselbe Störstellenverteilung besitzen wie Ro.

3. D/A-Wandler nach einem der Ansprüche 1 oder 2, dadurch gekennzeichnet,
— dass je eines der Paare von Schaltertransistoreinheiten bzw. Schaltertransistoren (T1, T2; T1', T2') mit je einer der Stromquellentransistoreinheiten (Tq1 ... Tqn; Tq') in Serie geschaltet ist, und
— dass die Emitteranschlüsse der Stromquellentransistoren (Tq1 ... Tqn) bzw. Stromquellentransistoreinheiten (Tq') über je einen gleichgrossen Widerstand (Rq) mit der Flussspannungsquelle (−Up) verbunden sind.

4. D/A-Wandler nach einem der Ansprüche 1 bis 3, dadurch gekennzeichnet, dass die Basisanschlüsse der in Basisschaltung betriebenen zweiten Transistoren (T2, T2') am Ausgang einer Spannungsquelle mit verschwindend kleinem Innenwiderstand gegen das Bezugspotential (Uo) liegen.

5. D/A-Wandler nach einem der Ansprüche 1 bis 4, dadurch gekennzeichnet, dass sowohl die Paare von Schaltertransistoreinheiten (T1', T2') und die Paare von Schaltertransistoren (T1, T2) untereinander als auch die Stromquellentransistoren (Tq) und die Stromquellentransistoreinheiten (Tq') untereinander dieselben Abmessungen und dieselben Störstellenverteilungen aufweisen.

6. D/A-Wandler nach einem der Ansprüche 1 bis 5, dadurch gekennzeichnet, dass die Schaltertransistorpaare im zweiten Wandlerteil (II) der gewichteten Ströme aus parallelgeschalteten Paaren von gleichartigen Transistoren (T1', T2') mit identischen Abmessungen und identischen Störstellenverteilungen bestehen.

7. D/A-Wandler nach einem der Ansprüche 1 bis 6, gekennzeichnet durch N=5 und M=2.

## Claims

1. Monolithic integrated D/A converter comprising bipolar current-source transistors (Tq) whose base regions are jointly connected to a reference voltage (Ur) and whose emitter regions are each connected through an emitter resistor (Rq) to a forward-voltage source (−Up) and which consist in part of similar current-source transistor units and whose individual collector regions are connected to the emitters of a least one pair of bipolar switching transistors which serve to switch the currents of the individual current-source transistors (Tq) between ground potential (Uo) and the output (A) and consist in part of pairs of similar switching-transistor units, with

— the base terminals of the first transistors (T1) of the switching-transistor pairs connected each to one of the bit lines (E),

— the collector terminals of these first transistors connected jointly to ground potential (Uo),

— the base terminals of the second transistors (T2) of the switching-transistor pairs connected jointly to the output of a voltage source (Ut), and

— the collector terminals of the second transistors connected to the output (A) of the converter, characterized in that

— the converter is divided into a first N-bit converter section (I) with weighted resistors and a second M-bit converter section (II) with weighted currents, in which second converter section (II) the collector terminals of the second transistors (T2') are all together connected directly to the output (A) of the converter,

— in the first converter section (I), n resistors are connected in series between ground potential (Uo) and the output (A), the first of which (R1) has a value of Ro, while the others (R2-Rn) have the values $Rn=2^{n-2}\cdot Ro$ for n=2, and

— each of the nodes of the n resistors (R1 ... Rn) is connected to the collector terminal of the second transistor (T2) of one of the switching-transistor pairs, while that terminal of the last resistor (Rn) located on the output side is connected to the output (A) directly and to the collector of the second transistor (T2) of the nth switching-transistor pair, so that the collectors of the second transistors (T2) in the first converter section (I), with the exception of that at the output end, are connected to the output (A) through at least one of the resistors R2 to Rn.

2. A D/A converter as claimed in Claim 1, characterized in that the resistors (R3, R4 ... Rn) having values different from Ro each consist of a series arrangement of similar resistors of resistance Ro which have the same dimensions and the same impurity distribution as the first resistor (R1) of resistance Ro.

3. A D/A converter as claimed in one of Claims 1 or 2, characterized in that

— each of the pairs of switching transistors and switching-transistor units (T1, T2; T1', T2') is connected in series with one of the current-source transistor units (Tq1 ... Tqn; Tq'), and

— the emitterr terminals of the current-source transistors (Tq1 ... Tqn) and current-source transistor units (Tq') are connected to the forward-voltage source (−up) through equal-value resistors (Rq).

4. A D/A converter as claimed in one of Claims 1 to 3, characterized in that the base terminals of the second transistors (T2, T2'), which are operated in a common-base configuration, are connected to the output of a voltage source of infinitely low internal resistance with respect to ground potential (Uo).

5. A D/A converter as claimed in one of Claims 1 to 4, characterized in that the pairs of switching-transistor units (T1', T2') and the pairs of switching transistors (T1, T2), on the one hand, and the current-source transistors (Tq) and the current-source transistor units (Tq'), on the other hand, have the same dimensions and the same impurity distribution among one another.

6. A D/A converter as claimed in one of Claims 1 to 5, characterized in that the switching-transistor pairs in the second converter section (II) with weighted currents consist of parallel-connected pairs of similar transistors (T1', T2') having identical dimensions and identical impurity distribution.

7. A D/A converter as claimed in one of Claims 1 to 6, characterized by N=5 and M=2.

## Revendications

1. Convertisseur N/A à intégration monolithique comprenant des transistors-sources de courant bipolaires (Tq) dont les zones de base sont reliées conjointement à une tension de référence (Ur), dont les zones d'émetteur sont reliées par une résistance d'émetteur (Rq) à une source de tension directe (−Up),constituées en partie par des unités de transistors-sources de courant similaires, et dont les zones de collecteur individuelles sont en contact avec les émetteurs d'au moins une paire de transistors-commutateurs bipolaires, qui servent à la commutation des courants des divers transistors-sources de courant (Tq) entre le potentiel de référence (Uo) et la sortie (A) et qui sont constitués en partie par des paires d'unités de transistors-commutateurs similaires montés en parallèle, et où

— les connexions de base des premiers transistors (T1) des paires de transistors-commutateurs sont connectées chacune à une des lignes de bits (E),

— les bornes de collecteur de ces premiers transistors sont reliées conjointement au potentiel de référence (Uo),

— les connexions de base des deuxièmes transistors (T2) des paires de transistors-commutateurs sont reliées conjointement à la sortie d'une source de tension (Ut), et

— les bornes de collecteur des deuxièmes transistors sont connectées à la sortie (A) du convertisseur, caractérisé en ce que

— le convertisseur est partagé en une première partie à N bits (I) ayant des résistances pondérées et en une deuxième partie à M bits (II) ayant des courants pondérés, deuxième partie (II) dans laquelle les bornes de collecteur des deuxièmes transistors (T2') sont connectées ensemble directement à la sortie (A) du convertisseur,

— on trouve entre le potentiel de référence (Uo) et la sortie (A), dans la première partie de convertisseur (I), un montage en série de n résistances dont la première résistance comporte une résistance Ro et dont les autres résistances (R2-Rn) présentent les valeurs $Rn = 2^{n-2} \cdot Ro$, avec $n = 2$ à n, et

— chacun des points de jonction des n résistances (R1 ... Rn) est connecté à une borne de collecteur d'un deuxième transistor (T2) d'une des paires de transistors-commutateurs, et la connexion côté sortie de la dernière résistance (Rn) se trouve directement reliée à la sortie (A) et au collecteur du deuxième transistor (T2) de la $n^{ième}$ paire de transistors-commutateurs, de telle sorte que les collecteurs des deuxièmes transistors (T2) de la première partie du convertisseur (I) sont reliés indirectement à la sortie (A) par au moins une des résistances R2 à Rn, à l'exception de celui qui est disposé côté sortie.

2. Convertisseur N/A selon la revendication 1, caractérisé en ce que les résistances (R3, R4 ... Rn) dont la valeur diffère de Ro sont constituées chacune par un montage en série de résistances identiques ayant la valeur de Ro et qui possèdent les mêmes dimensions et la même distribution d'impuretés que Ro.

3. Convertisseur N/A selon l'une des revendications 1 ou 2, caractérisé en ce que

— chacune des paires d'unités de transistors-commutateurs ou de transistors-commutateurs (T1, T2; T1', T2') est montée en série avec chacune des unités de transistors-sources de courant (Tq1 ... Tqn; Tq'), et

— les connexions d'émetteur des transistors (Tq1 ... Tqn) ou des unités de transistors-sources de courant (Tq') sont reliées au moyen de résistances respectives de même valeur (Rq) à la source de tension directe (−Up).

4. Convertisseur N/A selon l'une des revendications 1 à 3, caractérisé en ce que les connexions de base des deuxièmes transistors en un montage à base commune (T2, T2') sont connectées à la sortie d'une source de tension à résistance infiniment faible par rapport au potentiel de référence.

5. Convertisseur N/A selon l'une des revendications 1 à 4, caractérisé en ce que les paires d'unités de transistors-commutateurs (T1', T2') et les paires de transistors-commutateurs (T1, T2) présentent entre elles, de même que les transistors-sources de courant (Tq) et les unités de transistors-sources de courant (Tq') entre eux, les mêmes dimensions et les mêmes distributions d'impuretés.

6. Convertisseur N/A selon l'une des revendications 1 à 5, caractérisé en ce que les paires de transistors-commutateurs de la deuxième partie du convertisseur (II) à courants pondérés sont constituées par des transistors similaires (T1', T2') montés en parallèle, dont les dimensions et la distribution d'impuretés sont identiques.

7. Convertisseur N/A selon l'une des revendications 1 à 6, caractérisé en ce que N=5 et M=2.

FIG. 1

FIG. 2